# EUROPÄISCHE PATENTSCHRIFT

(11) **EP 2 675 935 B1**
(45) Veröffentlichungstag und Bekanntmachung des Hinweises auf die Patenterteilung: **07.04.2021**
(21) Anmeldenummer: 12705252.0
(22) Anmeldetag: 13.02.2012
(51) Int. Cl.: C23C 14/08, H01L 21/02, H01L 37/02, C23C 14/34, H01L 41/316

(54) **VERFAHREN ZUM HERSTELLEN EINES DÜNNFILMS AUS BLEI-ZIRKONAT-TITANAT**
METHOD FOR PRODUCING A THIN FILM MADE OF LEAD ZIRCONATE TITANATE
PROCÉDÉ DE FABRICATION D'UNE COUCHE MINCE DE TITANATE-ZIRCONATE DE PLOMB

(30) Priorität: 15.02.2011 DE 102011000752
(43) Veröffentlichungstag der Anmeldung: 25.12.2013
(73) Patentinhaber: Pyreos Ltd., Edinburgh EH9 3JF (GB)
(72) Erfinder: GIEBELER, Carsten, Heemsteede Longniddry EH32 0LF (GB); CONWAY, Neil, Dunfermline Fife KY12 8YL (GB)
(74) Vertreter: Mewburn Ellis LLP
(86) Internationale Anmeldenummer: PCT/EP2012/052419
(87) Internationale Veröffentlichungsnummer: WO 2012/110458

(56) Entgegenhaltungen:
- US-A- 5 196 101
- RAINER BRUCHHAUS ET AL: "Optimized PZT thin films for pyroelectric IR detector arrays", JOURNAL OF ELECTROCERAMICS JUNE 1999, Bd. 3, Nr. 2, 1. Juni 1999 (1999-06-01), Seiten 151-162, XP55024112, DOI: 10.1023/a:1009995126986
- C: Giebeler ET AL: "High performance PZT based pyro-detectors with D* of 2x10E9 cmHzE /W for presence, gas and spectroscopy applications", Proceedings OPTO 2009 & IRS2 2009; IRS2 1 - Infrared Sensors, 28. Mai 2009 (2009-05-28), Seiten 185-189, XP55024053, DOI: 10.5162/irs09/i1.1 ISBN: 978-3-98-109936-2 Gefunden im Internet: URL:http://www.ama-science.org/home-en-us/ details/157 [gefunden am 2012-04-05]
- A. A. BOGOMOLOV ET AL: "Photovoltaic and pyroelectric effects in self-polarized ferroelectric PZT(25/75) films", BULLETIN OF THE RUSSIAN ACADEMY OF SCIENCES: PHYSICS, Bd. 74, Nr. 9, 1. September 2010 (2010-09-01), Seiten 1307-1310, XP55023974, ISSN: 1062-8738, DOI: 10.3103/S1062873810090352
- SUCHANECK ET AL: "Multi-target reactive sputtering-A promising technology for large-area Pb(Zr,Ti)O3 thin film deposition", JOURNAL OF THE EUROPEAN CERAMIC SOCIETY, ELSEVIER SCIENCE PUBLISHERS, BARKING, ESSEX, GB, Bd. 27, Nr. 13-15, 1. Januar 2007 (2007-01-01), Seiten 3789-3792, XP022143635, ISSN: 0955-2219, DOI: 10.1016/J.JEURCERAMSOC.2007.02.032
- AKIRA FUJISAWA ET AL: "Effect of Zr/Ti ratio on crystal structure of thin lead zirconate-titanate films prepared by reactive sputtering", JAPANESE JOURNAL OF APPLIED PHYSICS, PART 1 (REGULAR PAPERS & SHORT NOTES), 1. September 1993 (1993-09-01), Seiten 4048-4051, XP55024098,
- SCHREITER M ET AL: "Sputtering of self-polarized PZT films for IR-detector arrays", APPLICATIONS OF FERROELECTRICS, 1998. ISAF 98. PROCEEDINGS OF THE ELEVENTH IEEE INTERNATIONAL SYMPOSIUM ON MONTREUX, SWITZERLAND 24-27 AUG. 1998, PISCATAWAY, NJ, USA,IEEE, US, 24 August 1998 (1998-08-24), pages 181-185, XP010347216, DOI: 10.1109/ISAF.1998.786665 ISBN: 978-0-7803-4959-9

## Beschreibung

Die Erfindung betrifft ein Verfahren zum Herstellen eines Dünnfilms aus Blei-Zirkonat-Titanat in 111-orientierter Perovskit-Struktur.

Ein Dünnfilm aus Blei-Zirkonat-Titanat findet in elektronischen Bauteilen Anwendung, wobei die vorteilhaften dielektrischen, pyroelektrischen und piezoelektrischen Eigenschaften des Blei-Zirkonat-Titanats genutzt werden. Derartige elektronische Bauteile sind beispielsweise Kondensatoren, Pyrodetektoren, Piezoaktoren oder Halbleiterspeicher.

Zur Herstellung des Bauteils wird herkömmlich auf einem Substrat eine erste Elektrodenschicht, darüber der Dünnfilm aus dem Blei-Zirkonat-Titanat und wiederum darüber eine zweite Elektrodenschicht abgeschieden. Der Dünnfilm aus dem Blei-Zirkonat-Titanat wird mit einem Dünnschichtverfahren erzeugt, das bekannterweise ein Sputterverfahren, ein CVD-Verfahren oder ein Sol-Gel-Verfahren ist. Beim Sputterverfahren wird ein Gasgemisch aus Argon und Sauerstoff in einem Vakuum durch eine Hochspannung zu einem Plasma ionisiert. Blei, Zirkon und Titan werden jeweils in Form eines Targets bereitgestellt, wobei die Targets als Kathode und das Substrat als Anode geschaltet sind. Beim Sputtern werden aus den Targets Atome herausgeschlagen, die auf dem Substrat unter Ausbilden des Dünnfilms abgeschieden werden. Das Substrat ist herkömmlich ein Silizium-Wafer, das in nachgelagerten Bearbeitungsschritten membranartig gefertigt wird.

Für die unterhalb des Dünnfilms auf dem Substrat angeordnete Elektrodenschicht ist als Elektrodenmaterial Platin geeignet, da es die Abscheidebedingungen des Blei-Zirkonat-Titanats bei hohen Substratemperaturen und in sauerstoffhaltiger Atmosphäre beim Sputtern unbeschadet überstehen kann und keine Diffusion in den Dünnfilm auftritt, die zu einer nachteilig veränderten Zusammensetzung und damit zu einer Verschlechterung der Eigenschaften des Dünnfilms führen könnte.

Die Ausprägung der pyroelektrischen Eigenschaft des Dünnfilms hängt von der Zusammensetzung des Dünnfilm mit Blei, Zirkon und Titan ab. Für die Anwendung des Dünnfilms in einem Infrarotsensor ist der Dünnfilm insbesondere mit einer Dicke von 0,2 bis 3 µm mit dem Sputterverfahren selbstpolarisiert hergestellt. Das Sputterverfahren ist mit einer gesamten Abscheiderate von Blei, Zirkon und Titan zwischen 1 bis 7 nm/min durchzuführen, wobei sich der Dünnfilm mit der 111-orientierten Perovskit-Struktur ausbildet und der Dünnfilm einen pyroelektrischen Koeffizienten zwischen 2·10⁻⁹ bis 5·10⁻⁴ C/m² hat.

Betreffender Stand der Technik wird beispielsweise in folgenden wissenschaftlichen Veröffentlichungen beschrieben:
RAINER BRUCHHAUS ET AL: "Optimized PZT thin films for pyroelectric IR detector arrays",JOURNAL OF ELECTROCERAMICS JUNE 1999, Bd. 3, Nr. 2, 1. Juni 1999 Seiten 151-162.

C. Giebeler ET AL: "High performance PZT based pyro-detectors with D* of 2x10E9 cmHz½/W for presence, gas and spectroscopy applications.",Proceedings OPTO 2009 & IRS2 2009; IRS2 1 - Infrared Sensors, 28. Mai 2009, Seiten 185-189.

A. A. BOGOMOLOV ET AL: "Photovoltaic and pyroelectric effects in self-polarized ferroelectric PZT(25/75) films",BULLETIN OF THE RUSSIAN ACADEMY OF SCIENCES: PHYSICS, Bd. 74, Nr. 9, 1. September 2010, Seiten 1307-1310.

G. SUCHANECK ET AL: "Multi-target reactive sputtering-A promising technology for large-area Pb(Zr,Ti)O3 thin film deposition",JOURNAL OF THE EUROPEAN CERAMIC SOCIETY, ELSEVIER SCIENCE PUBLISHERS, BARKING, ESSEX, GB, Bd. 27, Nr. 13-15, 1. Januar 2007, Seiten 3789-3792.

Nachteilig bei diesem Sputterverfahren ist es, dass die gesamte Abscheiderate von Blei, Zirkon und Titan von 1 bis 7 nm/min lediglich eine geringe Herstellgeschwindigkeit des Dünnfilms darstellt, so dass mit diesem Sputterverfahren lediglich eine geringe Durchsatzrate an Dünnfilmen zu erzielen ist, wodurch die Wirtschaftlichkeit dieses Sputterverfahrens zum Herstellen des Dünnfilms gering ist.

Im US Patent 5,196,101 sind Abscheideraten von 10-12 nm/min beschrieben. Der Blei-Zirkonat-Titanat Dünnfilm liegt in 101-Orientierung vor.

Aufgabe der Erfindung ist es, ein Verfahren zum Herstellen eines Dünnfilms aus Blei-Zirkonat-Titanat in 111-orientierter Perovskit-Struktur zu schaffen, wobei mit dem Verfahren eine hohe Durchsatzrate an Dünnfilmen erzielbar ist, obwohl der Dünnfilm einen hohen pyroelektrischen Koeffizienten hat.

Die Aufgabe wird gelöst mit den Merkmalen des unabhängigen Patentanspruchs 1. Vorteilhafte Ausgestaltungen dazu sind in den weiteren Patentansprüchen angegeben.

Das Sputtern von Blei, Zirkon und Titan von den jeweiligen Targets auf das Substrat ist bevorzugt konfokal und/oder gleichzeitig. Die Abscheiderate von Blei wird derart gewählt, dass die atomare Konzentration von Blei bezogen auf die atomare Konzentration von Zirkon zusammen mit Titan einen Dünnfilm zwischen 1,1 und 1,3 beträgt. Bei der Substrattemperatur von 500 bis 550°C wird bevorzugtermaßen die gesamte Abscheiderate von Blei, Zirkon und Titan zwischen 11 und 13 nm/min gewählt, wobei bevorzugtermaßen die Abscheiderate von Blei derart gewählt wird, dass die atomare Konzentration von Blei bezogen auf die atomare Konzentration von Zirkon zusammen mit Titan im Dünnfilm zwischen 1,24 und 1,29 beträgt, und bevorzugtermaßen die Abscheiderate von Zirkon derart gewählt wird, dass die atomare Konzentration von Zirkon bezogen auf die atomare Konzentration von Zirkon zusammen mit Titan im Dünnfilm zwischen 0,25 und 0,29 beträgt.

Der signifikante Spitzenwert des Röntgendiffraktometerdiagramms des Dünnfilms liegt bevorzugt bei dem Beugungswinkel von 34 bis 34,5°. Ferner wird bevorzugt der signifikante Spitzenwert des Röntgendiffraktometerdiagramms des Dünnfilms von Kristallen aus einem Zirkonoxid im Dünnfilm verursacht. Denkbar ist, dass das Zirkonoxid Zirkondioxid oder Zirkontrioxid usw. ist.

Der Dünnfilm wird bevorzugt so aufgebracht, dass der Dünnfilm selbstpolarisiert ist. In WO 00/17921 ist ein Verfahren zur Herstellung selbstpolarisierter ferroelektrischer Schichten, insbesondere aus Blei-Zirkonat-Titanat, beschrieben. Das erfindungsgemäße Verfahren weist bevorzugt ferner den Schritt auf: Polarisieren des Dünnfilms derart, dass der pyroelektrische Koeffizient des Dünnfilms größer als 10⁻⁴ C/m² ist. Bevorzugt hat der Dünnfilm eine Dicke zwischen 0,2 bis 3 µm.

Der mit dem erfindungsgemäßen Verfahren hergestellte Dünnfilm hat vorteilhaft einen hohen pyroelektrischen Koeffizienten, der etwa zwischen 1,2·10⁻⁹ bis 5·10⁻⁹ C/m² liegt, obwohl die gesamte Abscheiderate höher als 10 nm/min beträgt. Dieser vorteilhaft hohe pyroelektrische Koeffizient für den erfindungsgemäß hergestellten Dünnfilm wird bei der hohen gesamten Abscheiderate von mehr als 10 nm/min dadurch erreicht, dass die Abscheiderate von Zirkon derart gewählt wird, dass die atomare Konzentration von Zirkon bezogen auf die atomare Konzentration von Zirkon zusammen mit Titan im Dünnfilm zwischen 0,2 und 0,3 liegt, und die Abscheiderate von Blei in Abhängigkeit der Substrattemperatur und der gesamten Abscheiderate von Blei, Zirkon und Titan so niedrig gewählt wird, dass ein Röntgendiffraktometerdiagramm des 111-orientierten Blei-Zirkonat-Titanats im Bereich des Beugungswinkels von 33 bis 35,5° einen signifikanten Spitzenwert hat.

Bevorzugt liegt die gesamte Abscheiderate von Blei, Zirkon und Titan zwischen 10 nm/min und 50 nm/min, wobei der erfindungsgemäß hergestellte Dünnfilm in seinem Röntgendiffraktometerdiagramm bevorzugt bei dem Beugungswinkel von 34 bis 34,5° den signifikanten Spitzenwert aufweist. Durch das Auftreten des signifikanten Spitzenwerts im Röntgendiffraktometerdiagramm des erfindungsgemäß hergestellten Blei-Zirkonat-Titanats im Bereich des Beugungswinkels von 33 bis 35,5°, bevorzugt von 34 bis 34,5°, ist eine weitere Phase in dem Dünnfilm erzeugt, die von Kristallen aus einem Zirkonoxid verursacht wird. Das Zirkonoxid kann Zirkondioxid oder Zirkontrioxid oder dergleichen sein.

Wird hingegen ein Dünnfilm bei einer Substrattemperatur von 550°C hergestellt, wobei die Abscheiderate von Blei so gewählt wird, dass ein Röntgendiffraktometerdiagramm des Blei-Zirkonat-Titanats im Bereich des Beugungswinkels von 33 bis 35,5° keinen signifikanten Spitzenwert hat, so ist der erfindungsgemäß erzielbare hohe pyroelektrische Koeffizient nur dann zu erreichen, wenn die gesamte Abscheiderate von Blei, Zirkon und Titan weniger als 10 nm/min beträgt.

Dadurch, dass es mit dem erfindungsgemäßen Herstellverfahren ermöglicht ist, die gesamte Abscheiderate von Blei, Zirkon und Titan groß zu wählen, nämlich größer als 10 nm/min, kann mit dem erfindungsgemäßen Verfahren der Dünnfilm schnell und kostengünstig hergestellt werden, obwohl der Dünnfilm dennoch einen hohen pyroelektrischen Koeffizienten hat, nämlich etwa zwischen 1,2·10⁻⁹ bis 5·10⁻⁴ C/m².

Somit ist es vorteilhaft bei der gesamten Abscheiderate von Blei, Zirkon und Titan größer als 10 nm/min den Dünnfilm derart herzustellen, dass das Röntgendiffraktometerdiagramm des Dünnfilms im Bereich des Beugungswinkels von 33 bis 35,5° einen signifikanten Spitzenwert hat, da dadurch der pyroelektrische Koeffizient des Dünnfilms hoch ist.

Damit das Blei-Zirkonat-Titanat in der Perovskit-Struktur herstellbar ist, ist die Substrattemperatur von über 450°C zu wählen. Die atomare Konzentration von Zirkon bezogen auf die atomare Konzentration von Zirkon zusammen mit Titan im Dünnfilm ist im Wesentlichen unabhängig von der Höhe der Substrattemperatur. Da jedoch Blei eine bezogen auf die Substrattemperatur geringe Verdampfungstemperatur hat, ist das Verhältnis der Abscheiderate von Blei bezogen auf die Abscheiderate von Zirkon zusammen mit Titan entsprechend an die gewählte Substrattemperatur anzupassen, um ein erhöhtes Verdampfen von Blei von dem Substrat bei hohen Substrattemperaturen zu kompensieren. Analog ist bei niedrig gewählter Substrattemperatur die Abscheiderate für Blei entsprechend herabzusenken, da die Verdampfung von Blei reduziert ist. Würde bei der niedrigen Substrattemperatur dennoch die Abscheiderate von Blei zu groß sein, so ist die atomare Konzentration von Blei bezogen auf die atomare Konzentration von Zirkon zusammen mit Titan im Dünnfilm zu hoch, wodurch die 111-Orientierung des Blei-Zirkonat-Titanats nicht erzielbar wäre.

Um die 111-Orientierung der Perovskit-Struktur des Blei-Zirkonat-Titanats zu erhalten, ist dem abgeschiedenen Blei, Zirkon und Titan mit einer entsprechend hoch gewählten Substrattemperatur eine Aktivierungsenergie bereitzustellen, wodurch das Blei-Zirkonat-Titanat in der 111-orientierten Perovskit-Struktur ausgebildet wird. Es ist bevorzugt beim Sputtern Blei, Zirkon und Titan gleichzeitig auf das Substrat aufzubringen, wodurch sich Blei, Zirkon und Titan zu dem Blei-Zirkonat-Titanat in der 111-orientierten Perovskit-Struktur ausbilden.

Prinzipiell ist es wünschenswert das Sputtern bei möglichst hohen Abscheideraten von Blei, Zirkon und Titan durchzuführen, da dabei die Durchsatzrate bei der Herstellung des Dünnfilms hoch ist. Jedoch ist bei ungeeignet hoch gewählten Abscheideraten von Blei, Zirkon und Titan nicht mehr genügend Zeit vorhanden, damit sich Blei, Zirkon und Titan in die 111-orientierte Perovskit-Struktur anordnen, da pro Zeiteinheit zu viel Material von den Targets auf das Substrat abgeschieden wird. Um dies zu kompensieren, könnte die Substrattemperatur weiter erhöht werden, wobei mit der Erhöhung der Substrattemperatur eine Erhöhung der Aktivierungsenergie einhergehen müsste, so dass sich die Wahrscheinlichkeit erhöht, dass sich Blei, Zirkon und Titan in der 111-orientierten Perovskit-Struktur anordnen. Im Zuge dessen ist jedoch aufgrund der erhöhten Substrattemperatur die Abscheiderate von Blei zu erhöhen.

Das hier offenbarte elektronische Bauteil weist als das Substrat eine Membran und den Dünnfilm auf, der auf der Membran aufgebracht ist, wobei der Dünnfilm aus Blei-Zirkonat-Titanat in der 111-orientierten Perovskit-Struktur mit dem erfindungsgemäßen Verfahren hergestellt ist. Das Bauteil wird als eine Wärmebildkamera, ein Präsenzmelder, ein Bewegungsmelder, ein Gasdetektor, ein Gestenerkennungsdetektor, ein Spektroskop und/oder ein Terahertzdetektor verwendet.

Das Substrat ist bevorzugt ein Silizium-Wafer, auf dem die Membran aus Siliziumdioxid und/oder Siliziumnitrid und/oder Siliziumodioxid aufgebracht ist. Auf der Membran wird eine Elektrode mit einer Haftschicht, beispielsweise aus Aluminiumoxid (Al₂O₃) oder Titan, gefolgt von einer Platinschicht aufgebracht. Der Dünnfilm wird ganzflächig auf die Platinschicht aufgebracht. In einem nachfolgenden Schritt werden beide Schichten so strukturiert, dass sich ein Pixel oder mehrere Pixel in einem Flächenabschnitt auf der Vorderseite der Membran ausbilden. Das Material des Silizium-Wafers ist auf der dem Dünnfilm abgewandten Seite so abgetragen, dass die Membran zumindest im Bereich des Flächenabschnitts rückseitig freigelegt und thermisch isoliert ist.

Im Folgenden wird die Erfindung anhand der beigefügten schematischen Zeichnungen erläutert. Es zeigen:
Figur 1 ein Röntgendiffraktometerdiagramm von Blei-Zirkonat-Titanat eines erfindungsgemäß hergestellten Dünnfilms;
Figur 2 einen Ausschnitt des Röntgendiffraktometerdiagramms aus Figur 1; und
Figur 3 ein Röntgendiffraktometerdiagramm von Blei-Zirkonat-Titanat eines herkömmlich hergestellten Dünnfilms.

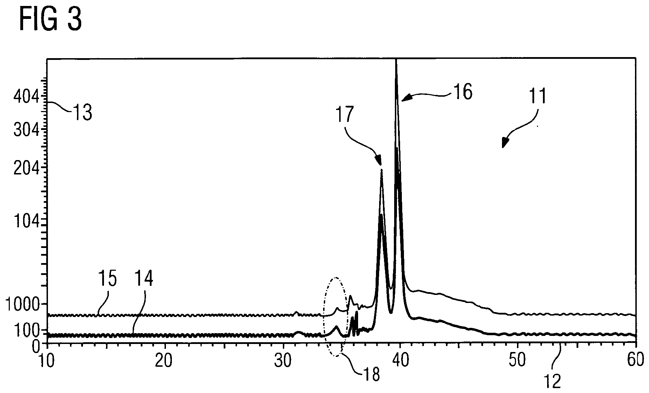

In Figur 3 ist ein Röntgendiffraktometerdiagramm 11 von Blei-Zirkonat-Titanat gezeigt, das gemäß einem herkömmlichen Sputterverfahren hergestellt wurde. Das Röntgendiffraktometerdiagramm 11 hat eine Abszisse 12, über die der Beugungswinkel, und eine Ordinate 13, über die die Amplitude aufgetragen sind. Der Dünnfilm wurde auf ein Substrat aufgebracht, wobei das Substrat ein Silikon-Wafer ist.

Eine erste Kurve 14 und eine zweite Kurve 15 zeigen jeweils das Spektrum von Blei-Zirkonat-Titanat eines Dünnfilms. Die Dünnfilme wurden mit dem herkömmlichen Sputterverfahren auf das Substrat aufgebracht, wobei gemäß der ersten Kurve 14 die Substrattemperatur 500°C und gemäß der zweiten Kurve 15 die Substrattemperatur 550°C betragen hat. Beide Dünnfilme wurden bei einer gesamten Abscheiderate von Blei, Zirkon und Titan von 5 nm/min hergestellt, wobei der pyroelektrische Koeffizient etwa 2·10⁻⁴ C/m² beträgt.

In beiden Kurven 14 und 15 ist ein signifikanter Spitzenwert 16 von Platin und ein signifikanter Spitzenwert 17 von Blei-Zirkonat-Titanat in 111-orientierter Perovskit-Struktur zu erkennen. Der leicht unruhige Verlauf der Kurven 14 und 15 ist auf Grundrauschen zurückzuführen. Im Beugungswinkelbereich 18 von 33 bis 35,5° tritt ein signifikanter Spitzenwert nicht auf.

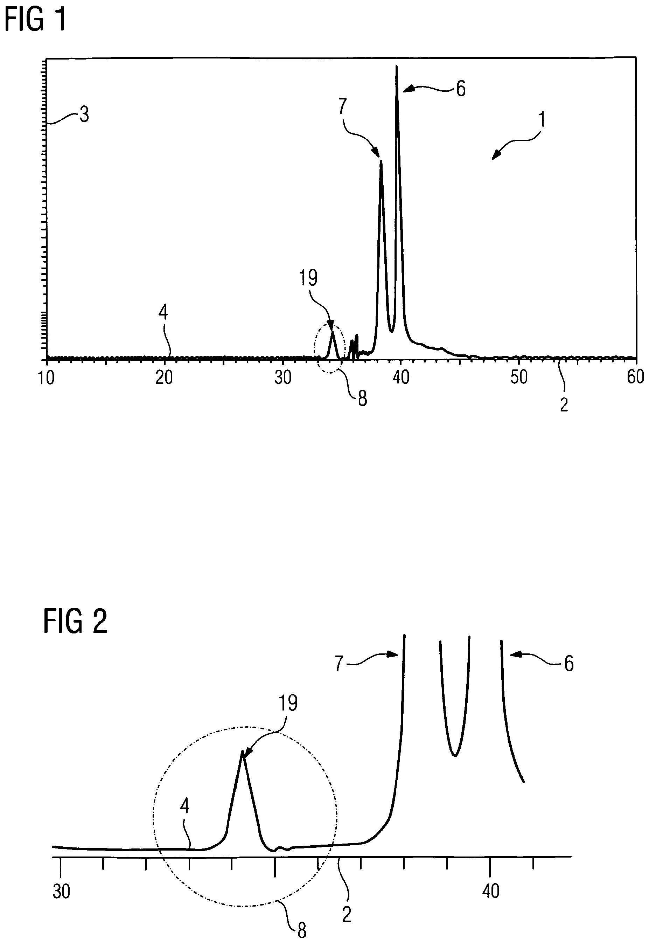

In Figur 1 ist ein Röntgendiffraktometerdiagramm 1 von Blei-Zirkonat-Titanat gezeigt, das gemäß einer dritten Kurve 4 mit dem erfindungsgemäßen Verfahren hergestellt wurde. Für das erfindungsgemäße Verfahren wurde eine gesamte Abscheiderate von Blei, Zirkon und Titan von 15 nm/min verwendet. Das Röntgendiffraktometerdiagramm 1 weist eine Abszisse 2, über die der Beugungswinkel, und eine Ordinate 3 auf, über die die Amplitude aufgetragen sind. Der Dünnfilm wurde auf ein Substrat aufgebracht, das ein Silikon-Wafer ist.

Die dritte Kurve 4 weiset einen signifikanten Spitzenwert 6 von Platin und einen signifikanten Spitzenwert 7 von Blei-Zirkonat-Titanat in 111-orientierter Perovskit-Struktur auf. Beim Herstellen des Dünnfilms wurde das Substrat mit einer Substrattemperatur 550°C bereitgestellt. Der Dünnfilm wurde durch Sputtern von Blei, Zirkon und Titan unter Verwendung eines Blei-Targets, eines Zirkon-Targets und eines Titan-Targets auf das Substrat aufgebracht, wobei die gesamte Abscheiderate von Blei, Zirkon und Titan 15 nm/min betrug.

Für den Dünnfilm gemäß der dritten Kurve 4 wurde die Abscheiderate von Blei derart gewählt, dass die atomare Konzentration von Blei bezogen auf die atomare Konzentration von Zirkon zusammen mit Titan im Dünnfilm zwischen 1,24 und 1,26 beträgt. Der pyroelektrische Koeffizient des Dünnfilms gemäß der dritten Kurve 4 beträgt 2·10⁻⁴ C/m².

Der Beugungswinkelbereich 8 zwischen 33 bis 35,5° ist im Detail in Figur 2 gezeigt. In der dritten Kurve 4 ist ein signifikanter Spitzenwert bei dem Beugungswinkel von 34 bis 34,5° ausgebildet. Im Gegensatz dazu haben die Kurven 14 und 15 in Figur 3 im Beugungswinkelbereich 8 zwischen 33 bis 35,5° keinen signifikanten Spitzenwert hat. Der signifikante Spitzenwert 19 bei dem Beugungswinkel von 34 bis 34,5° ist lediglich in der dritten Kurve 4 und nicht in der ersten Kurve 14 und der zweiten Kurve 15 ausgebildet.

### Bezugszeichenliste

1 Röntgendiffraktometerdiagramm
   (gesamte Abscheiderate bei 15 nm/min)
2 Abszisse: Beugungswinkel
3 Ordinate: Amlitude
4 dritte Kurve
6 signifikanter Spitzenwert von Blei
7 signifikanter Spitzenwert von Blei-Zirkonat-Titanat
8 Beugungswinkelbereich von 33 bis 35,5°
9 signifikanter Spitzenwert bei dem Beugungswinkel von 34 bis 34,5°
11 Röntgendiffraktometerdiagramm
   (gesamte Abscheiderate bei 5 nm/min)
12 Abszisse: Beugungswinkel
13 Ordinate: Amlitude
14 erste Kurve (Substrattemperatur bei 450°C)
15 zweite Kurve (Substrattemperatur bei 550°C)
16 Signifikanter Spitzenwert von Blei
17 Signifikanter Spitzenwert von Blei-Zirkonat-Titanat
18 Beugungswinkelbereich von 33 bis 35,5°

## Patentansprüche

1. Verfahren zum Herstellen eines Dünnfilms aus Blei-Zirkonat-Titanat in 111-orientierter Perowskit-Struktur, mit den Schritten:
- Bereitstellen eines Substrats mit einer Substrattemperatur von 500 bis 550°C und eines Blei-Targets, eines Zirkon-Targets und eines Titan-Targets;
- Aufbringen des Dünnfilms durch Sputtern von Blei, Zirkon und Titan von den jeweiligen Targets auf das Substrat, wobei
-- die gesamte Abscheiderate von Blei, Zirkon und Titan größer als 10 nm/min ist,
-- die Abscheiderate von Zirkon derart gewählt wird, dass die atomare Konzentration von Zirkon bezogen auf die atomare Konzentration von Zirkon zusammen mit Titan im Dünnfilm zwischen 0,2 und 0,3 liegt, und
-- die Abscheiderate von Blei in Abhängigkeit der Substrattemperatur und der gesamten Abscheiderate von Blei, Zirkon und Titan so niedrig gewählt wird, dass ein Röntgendiffraktometerdiagramm des 111-orientierten Blei-Zirkonat-Titanats im Bereich des Beugungswinkels von 33 bis 35,5° einen signifikanten Spitzenwert (19) hat;
-- die Abscheiderate von Blei derart gewählt wird, dass die atomare Konzentration von Blei bezogen auf die atomare Konzentration von Zirkon zusammen mit Titan im Dünnfilm zwischen 1,1 und 1,3 beträgt; und
- Fertigstellen des Dünnfilms.

2. Verfahren gemäß Anspruch 1, wobei das Sputtern von Blei, Zirkon und Titan von den jeweiligen Targets auf das Substrat konfokal und/oder gleichzeitig ist.

3. Verfahren gemäß Ansprüche 1 oder 2, wobei bei der Substrattemperatur von 500 bis 550 °C die gesamte Abscheiderate von Blei, Zirkon und Titan zwischen 11 und 13 nm/min gewählt wird, die Abscheiderate von Blei derart gewählt wird, dass die atomare Konzentration von Blei bezogen auf die atomare Konzentration von Zirkon zusammen mit Titan im Dünnfilm zwischen 1,24 und 1,29 beträgt, und die Abscheiderate von Zirkon derart gewählt wird, dass die atomare Konzentration von Zirkon bezogen auf die atomare Konzentration von Zirkon zusammen mit Titan im Dünnfilm zwischen 0,25 und 0,29 beträgt.

4. Verfahren gemäß einem der Ansprüche 1 bis 3, wobei der signifikante Spitzenwert des Röntgendiffraktometerdiagramms des Dünnfilms bei dem Beugungswinkel von 34 bis 34,5° liegt.

5. Verfahren gemäß einem der Ansprüche 1 bis 3, wobei der signifikante Spitzenwert des Röntgendiffraktometerdiagramms des Dünnfilms von Kristallen aus einem Zirkonoxid im Dünnfilm verursacht wird.

6. Verfahren gemäß einem der Ansprüche 1 bis 5, wobei der Dünnfilm so aufgebracht wird, dass der Dünnfilm selbstpolarisiert ist.

7. Verfahren gemäß einem der Ansprüche 1 bis 6, mit dem Schritt: Polarisieren des Dünnfilms derart, dass der pyroelektrische Koeffizient des Dünnfilms größer als 10⁻⁴ C/m² ist.

8. Verfahren gemäß einem der Ansprüche 1 bis 7, wobei der Dünnfilm eine Dicke zwischen 0,2 bis 3 µm hat.

## Claims

1. A method for producing a thin film made of lead zirconate titanate in 111-oriented perovskite structure, with the steps:
- providing a substrate having a substrate temperature of 500 to 550°C and a lead target, a zirconium target and a titanium target;
- applying the thin film by sputtering of lead, zirconium and titanium from the respective targets onto the substrate, wherein
-- the total deposition rate of lead, zirconium and titanium is greater than 10 nm/min,
-- the deposition rate of zirconium is selected in such a way that the atomic concentration of zirconium based on the atomic concentration of zirconium together with titanium in the thin film is between 0.2 and 0.3, and
-- the deposition rate of lead depending on the substrate temperature and the total deposition rate of lead, zirconium and titanium is selected so low that a X-ray diffractometer diagram of the 111-oriented lead zirconate titanate has a significant peak value (19) in the region of the diffraction angle of 33 to 35.5° ;
-- the deposition rate of lead is selected in such a way that the atomic concentration of lead based on the atomic concentration of zirconium together with titanium in the thin film is between 1.1 and 1.3; and
- finishing the thin film.

2. A method according to claim 1, wherein the sputtering of lead, zirconium and titanium from the respective targets onto the substrate is confocal and/ or simultaneous.

3. A method according to claims 1 or 2, wherein, at the substrate temperature of 500 to 550°C, the total deposition rate of lead, zirconium and titanium is selected between 11 and 13 nm/min, the deposition rate of lead is selected in such a way that the atomic concentration of lead based on the atomic concentration of zirconium together with titanium in the thin film is between 1.24 and 1.29, and the
the deposition rate of zirconium is selected in such a way that the atomic concentration of zirconium based on the atomic concentration of zirconium together with titanium in the thin film is between 0.25 and 0.29.

4. A method according to any one of claims 1 to 3, wherein the significant peak value of the X-ray diffractometer diagram of the thin film is at the diffraction angle of 34 to 34.5°.

5. A method according to any one of claims 1 to 3, wherein the significant peak value of the X-ray diffractometer diagram of the thin film is caused by crystals of a zirconia in the thin film.

6. A method according to any one of claims 1 to 5, wherein the thin film is applied such that the thin film is self-polarized.

7. A method according to any one of claims 1 to 6, with the step: polarizing the thin film in such a way that the pyroelectric coefficient of the thin film is greater than 10⁻⁴ C/m².

8. A method according to any one of claims 1 to 7, wherein the thin film has a thickness between 0.2 to 3 µm.

## Revendications

1. Procédé de fabrication d'une couche mince de zirconate et titanate de plomb selon une structure de pérovskite d'orientation 111, comportant les étapes :
- fourniture d'un substrat ayant une température de substrat de 500 à 550 °C et d'une cible de plomb, d'une cible de zirconium et d'une cible de titane ;
- application de la couche mince sur le substrat, par pulvérisation du plomb, du zirconium et du titane provenant des différentes cibles, dans lequel
- la vitesse globale de dépôt du plomb, du zirconium et du titane est supérieure à 10 nm/min,
- la vitesse de dépôt du zirconium est choisie de façon que la concentration en atomes du zirconium, rapportée à la concentration en atomes du zirconium et du titane dans la couche mince, soit comprise entre 0,2 et 0,3, et
- la vitesse de dépôt du plomb est, en fonction de la température du substrat et de la vitesse de dépôt globale du plomb, du zirconium et du titane, choisie à une valeur suffisamment faible pour qu'une image de diffraction aux rayons X du zirconate et titanate de plomb d'orientation 111 présente, dans la zone de l'angle de diffraction de 33 à 35,5°, une valeur de crête significative (19) ;
- la vitesse de dépôt du plomb est choisie de façon que la concentration en atomes du plomb, rapportée à la concentration en atomes du zirconium et du titane dans la couche mince, soit comprise entre 1,1 et 1,3, et
- finition de la couche mince.

2. Procédé selon la revendication 1, dans lequel la pulvérisation, sur le substrat, du plomb, du zirconium et du titane à partir des cibles correspondantes, est confocale et/ou simultanée.

3. Procédé selon la revendication 1 ou 2, dans lequel, à la température du substrat de 500 à 550 °C, la vitesse de dépôt global du plomb, du zirconium et du titane est choisie entre 11 et 13 nm/min, la vitesse de dépôt du plomb est choisie de façon que la concentration en atomes du plomb, rapportée à la concentration en atomes du zirconium et du titane dans la couche mince, soit comprise entre 1,24 et 1,29, et la vitesse de dépôt du zirconium est choisie de façon que la concentration en atomes du zirconium, rapportée à la concentration en atomes du zirconium et du titane dans la couche mince, soit comprise entre 0,25 et 0,29.

4. Procédé selon l'une des revendications 1 à 3, dans lequel la valeur de crête significative de l'image de diffraction aux rayons X de la couche mince corresponde à l'angle de diffraction de 34 à 34,5°.

5. Procédé selon l'une des revendications 1 à 3, dans lequel la valeur de crête significative de l'image de diffraction aux rayons X de la couche mince est provoquée par des cristaux d'un oxyde de zirconium dans la couche mince.

6. Procédé selon l'une des revendications 1 à 5, dans lequel la couche mince est appliquée de telle sorte que la couche mince soit autopolarisée.

7. Procédé selon l'une des revendications 1 à 6, comportant l'étape de polarisation de la couche mince de telle sorte que le coefficient pyroélectrique de la couche mince soit supérieur à 10⁻⁴ C/m².

8. Procédé selon l'une des revendications 1 à 7, dans lequel la couche mince présente une épaisseur entre 0,2 et 3 µm.
